# EUROPEAN PATENT APPLICATION

(11) **EP 3 477 708 A1**
(43) Date of publication of application: **01.05.2019**
(21) Application number: 17833494.2
(22) Date of filing: 21.07.2017
(51) Int. Cl.: H01L 31/048, H01L 31/054

(54) **SOLAR CELL MODULE**

(30) Priority: 29.07.2016 CN 201620817417 U
(71) Applicant: BYD Company Limited, Shenzhen 518118 (CN)
(72) Inventor: SUN, Xiang, Shenzhen Guangdong 518118 (CN); YAO, Yunjiang, Shenzhen Guangdong 518118 (CN); JIANG, Zhanfeng, Shenzhen Guangdong 518118 (CN)
(74) Representative: Hoffmann Eitle
(86) International application number: PCT/CN2017/093951
(87) International publication number: WO 2018/019191

(57) **Abstract**

The present disclosure provides a solar cell assembly, comprising a front plate, a front glue film layer, a cell piece array, a back glue film layer and a back plate which are sequentially stacked, wherein the front plate comprises glass, a side, deviating from the cell piece array, of the glass is provided with one or more light scattering units, and each light scattering unit is of a sunken structure formed when the side, deviating from the cell piece array, of the glass is sunken inwards towards a side, adjacent to the cell piece array, of the glass. The present disclosure provides that the light scattering unit is not needed to correspond to a non gate line portion of a cell piece, a requirement for type correspondence of the glass and the cell piece is not high, it is guaranteed that a whole silicon wafer can utilize incident light rays very well, a light receiving area of the glass is increased, assembly power is improved, and assembly installing cost is lowered.

## Description

### FIELD

The present disclosure relates to a solar cell assembly.

### BACKGROUND

In recent years, crude oil price fast and continuously rises, and meanwhile, bulk mining and consumption of conventional energy, namely petroleum, coal and the like, bring serous influences on the environment, thus people pay attention to new clean energy. Solar photovoltaic power generation is fast developed in this case, wherein a crystal (monocrystalline silicon or polycrystalline silicon) type solar cell (assembly) has formed industrialization. Along with the progress of technology, a power generation rate of a thin film type solar cell assembly is increased day by day, thus a thin film type cell assembly is also in fast development, and how to further improve output power of the solar cell (assembly) becomes an important subject urgently needing to be solved in the current solar photovoltaic power generation industry.

The crystal type solar cell (assembly) in the prior art is composed of embossed ultra-white protective glass, a filling material such as EVA, a plurality of crystal substrates (solar cell chips) connected (connected in series or connected in parallel) through wires, and a back side protective layer. The elements are pressed into a whole by a heating layer of a vacuum heat laminating machine, then a frame and a junction box are installed, and the complete solar cell (assembly) is formed.

According to the thin film type cell (assembly), a transparent electrode layer, a thin film semiconductor layer and a rear surface electrode layer are directly formed on a protective glass surface in sequence, then all layers are cut apart with laser or by other means according to requirements, then all portions are connected, and then back side protection is carried out by using the filling material such as EVA and a back side protecting film.

Sunlight penetrates through the protective glass and is irradiated onto the solar cell chip to generate a photovoltaic effect, not all the sunlight irradiated onto the cell chip is utilized, and much of the sunlight is reflected by the cell chip.

A solar cell is disclosed by CN 101677112A in the prior art, and particularly light concentrating glass is disclosed, and is used for reflecting light concentrating patterns, of which the whole surface has a strip shape, and which faces the solar cell chip. And an area proportion of a reflecting light concentration surface portion in the patterns is greater than or equal to 75%. The whole surface (namely, a lower surface of the glass), facing the solar cell chip, of the solar cell chip is manufactured into an array structure with a bump structure curved surface, a light receiving area is increased, and power of the assembly is improved. Light rays are focused on a cell piece between fine gate lines through a convex surface, the light rays are sufficiently utilized, and the power is further improved. But due to the fact that the above effect can be achieved only when convex patterns of the glass correspond to the cell piece between the fine gate lines, type correspondence of the glass and the cell piece is very high, meanwhile layout and arrangement of the assembly in actual production have deviation, that is, the bump structure portion of the glass needs to correspond to the non gate line portion of the cell piece, but certain operation deviation exists after the cell piece is subjected to the process such as printing, series connection and press fit, and a dislocation non-correspondence phenomenon occurs to a cell piece array and a glass convex pattern array very easily. In addition, requirements for the glass convex pattern array are different due to a difference of the type and the size of the cell piece, so that the light rays may not be focused on the cell piece between the gate lines after passing through the light concentrating glass, it cannot be guaranteed that a whole silicon wafer can well utilize incident light rays very well, and therefore there are negative effects on improvement of the assembly power.

### SUMMARY

In order to achieve the technical purpose that convex patterns in the prior art need to correspond to a cell piece between fine gate lines, a requirement for type correspondence of glass and the cell piece is high. Layout and arrangement of an assembly in actual production have deviation, it cannot be guaranteed that a whole silicon wafer can utilize incident light rays very well, and there are negative effects on improvement of assembly power. The present disclosure provides a solar cell assembly, wherein light scattering units are not needed to correspond to the cell piece between the fine gate lines, the requirement for type correspondence of the glass and the cell piece is not high, it is guaranteed that the whole silicon wafer can utilize the incident light rays very well, a light receiving area is increased, and power is effectively improved. And meanwhile assembly installing cost is lowered.

The solar cell assembly provided by the present disclosure comprises a front plate, a front glue film layer, a cell piece array, a back glue film layer and a back plate which are sequentially stacked, wherein the front plate comprises glass, a side, deviating from the cell piece array, of the glass is provided with one or more light scattering units, and the light scattering units are of a sunken structure formed when the side, deviating from the cell piece array, of the glass is sunken inwards towards a side, adjacent to the cell piece array, of the glass.

Preferably, a ratio of a maximum depth H₁ of the sunken structure to a thickness H of the glass is (1 to 100) to (1 to 2).

Preferably, the maximum depth H₁ of the sunken structure is 0.03 mm to 10 mm, and a width W₁ of the sunken structure is 0.3 mm to 50 mm.

Preferably, the relationship between a length L₁ of the sunken structure and a length L of the glass is L-60 mm≤L₁≤L-10 mm.

Preferably, an orthographic projection of each light scattering unit on a plane where a light receiving surface of the cell piece array is located is rectangular.

Preferably, the light scattering unit is of a sunken structure extending in a length direction of the glass.

Preferably, the plurality of light scattering units are distributed at intervals in a width direction of the glass, and adjacent light scattering units are connected in a circular arc transition manner.

Further, the sunken structure of the light scattering unit and a bump structure in circular arc transition form a wave shape extending in the width direction of the glass.

Preferably, the plurality of light scattering units are continuously distributed at equal intervals in the width direction of the glass, and a distance D₁ between edges of the adjacent light scattering units is 0.03 mm to 5 mm.

Preferably, the solar cell assembly further comprises an installing outer frame, edges all around the front plate/the front glue film layer/the cell piece array/the back glue film layer/the back plate are coated with the installing outer frame to seal the solar cell assembly, and the side, deviating from the cell piece array, of the glass located in the installing outer frame is a plane.

Preferably, a bottom surface of the glass is a smooth surface or a sueded surface.

The solar cell assembly of the present disclosure comprises the front plate, one or more glass formed by the sunken structure is arranged on the side, deviating from the cell piece array, of the glass, and the light scattering unit is of the sunken structure extending in the length direction of the glass. By changing a shape or a structure of the side, deviating from the cell piece array, of the glass, the light receiving area of the glass is increased, the light scattering units are not needed to correspond to the non gate line portion of the cell piece, and cell pieces in various types are all suitable. The light rays enter the cell piece after being scattered through the glass of the sunken structure, sunlight is fully utilized, it can be guaranteed that the whole cell piece array all receives light and generates power, and the assembly power is effectively improved. By adopting the solar cell assembly of the present disclosure, the sunlight in various time periods of one day may also be effectively utilized without adopting a sun chasing system, and cell assembly installing cost is lowered.

### BRIEF DESCRIPTION OF THE DRAWINGS

FIG. 1 is a structural schematic view of a front plate in a solar cell assembly of an embodiment of the present disclosure;
FIG. 2 is a top view of the front plate in the solar cell assembly of the embodiment of the present disclosure;
FIG. 3 is a side cutting view of the front plate in the solar cell assembly of the embodiment of the present disclosure;
FIG. 4 is a structural schematic view of the solar cell assembly of the embodiment of the present disclosure; and
FIG. 5 is a structural schematic view of the solar cell assembly of the embodiment of the present disclosure.

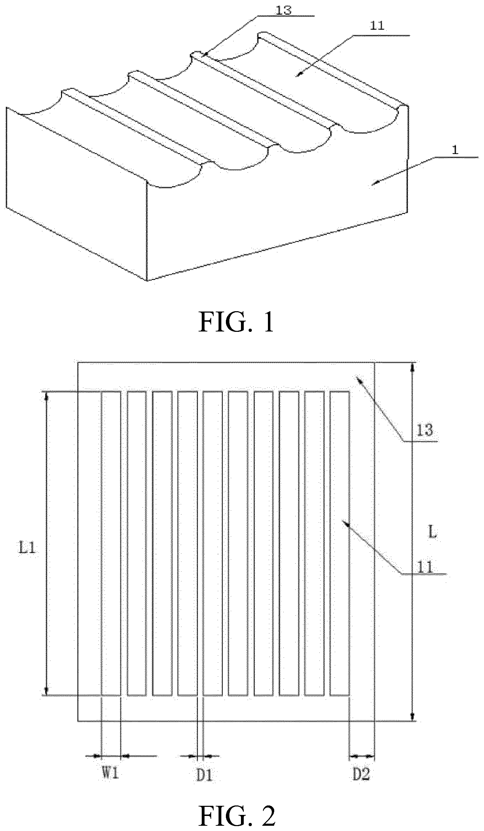

FIG. 1 to FIG. 5 comprise:
   1-glass, 2-front glue film layer, 3-cell piece array, 4-back glue film layer, 5-back plate, 6-installing frame, 11-light scattering unit, 12-encapsulation edge, 13-bump structure.

### DETAILED DESCRIPTION

To make the technical problems to be solved by the present disclosure, technical solutions, and beneficial effects more comprehensible, the following further describes the present disclosure in detail with reference to the accompanying drawings and embodiments. It should be understood that the specific embodiments described therein are merely used for explain the present disclosure instead of limiting the present disclosure.

Reference will be made in detail to embodiments of the disclosure. The embodiments described herein with reference to drawings are explanatory, illustrative, and should be used to generally understand the present disclosure. The embodiments described below with reference to the accompanying drawings are exemplary, aiming to explain the disclosure, but cannot be understood as a limitation on the disclosure.

In the description of the present disclosure, it should be understood that orientation or position relationships indicated by the terms such as "center", "longitudinal", "transverse", "length", "width", "thickness", "on", "below", "front", "rear", "left", "right", "vertical", "horizontal", "top", "bottom", "inside", "outside", "clockwise", and "counterclockwise" are based on orientation or position relationships shown in the accompanying drawings, and are used only for ease and brevity of illustration and description, rather than indicating or implying that the mentioned apparatus or component must have a particular orientation or must be constructed and operated in a particular orientation. Therefore, such terms should not be construed as limiting of the present disclosure.

In addition, the terms such as "first" and "second" are used only for the purpose of description, and should not be understood as indicating or implying the relative importance or implicitly specifying the number of the indicated technical features. Therefore, a feature defined by "first" or "second" can explicitly or implicitly include one or more of said features. In the description of the present disclosure, "plurality of" means at least two, for example, two, three, and so on, unless otherwise explicitly defined.

In the present disclosure, unless otherwise explicitly specified or defined, the terms such as "mount", "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two components or interaction between two components unless otherwise explicitly defined. Those of ordinary skill in the art can understand specific meanings of the terms in the disclosure according to specific situations.

In the disclosure, unless explicitly specified or limited otherwise, a first characteristic "on" or "under" a second characteristic may be the first characteristic in direct contact with the second characteristic, or the first characteristic in indirect contact with the second characteristic by using an intermediate medium. In addition, the first feature being "over", "above" or "on the top of" a second feature may include that the first feature is over or above the second feature or merely indicates that the horizontal height of the first feature is higher than that of the second feature. The first feature being "underneath", "below" or "on the bottom of" a second feature may include that the first feature is underneath or below the second feature or merely indicates that the horizontal height of the first feature is lower than that of the second feature.

The present disclosure is further described below in conjunction with the accompanying drawings and the embodiments.

The present disclosure provides a solar cell assembly, comprising a front plate, a front glue film layer 2, a cell piece array 3, a back glue film layer 4 and a back plate 5 which are sequentially stacked, the front plate is commonly a transparent body, so as to enhance transmittance, light rays are enabled to penetrate through the front plate to be irradiated onto the cell piece array, and cell assembly power is improved. Specifically, glass may be adopted:

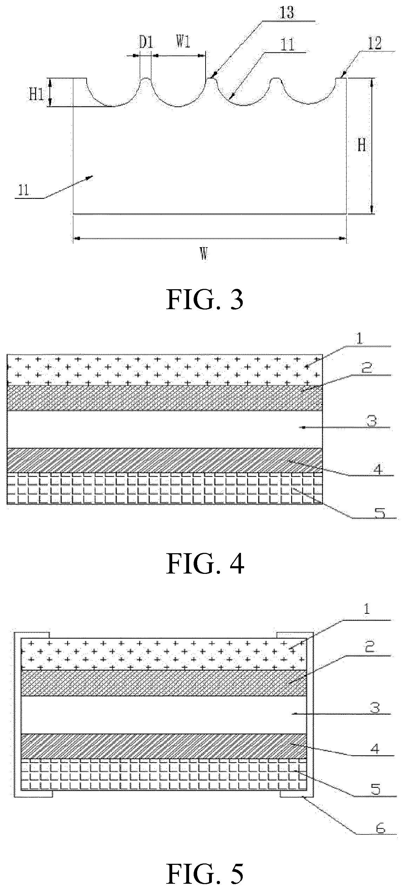

It is specifically as shown in FIG. 4 in the embodiment that the glass 1, the front glue film layer 2, the cell piece array 3, the back glue film layer 4 and the back plate 5 are sequentially arranged from top to bottom. As shown in FIG. 1, a side, deviating from the cell piece array 3, of the glass 1 is provided with one or more light scattering units 11, wherein the light scattering units 11 are of a sunken structure formed when the side, deviating from the cell piece array 3, of the glass 1 is sunken inwards towards a side, adjacent to the cell piece array 3, of the glass 1. Herein, one side of the glass refers to one side of the glass itself, and is not a side of a film layer arranged on one side of the glass.

By changing a shape or a structure of the side, deviating from the cell piece array, of the glass 1, a light receiving area of the glass 1 is increased, the light scattering units 11 are not needed to correspond to a non gate line portion of a cell piece, and a requirement for type correspondence of the glass 1 and the cell piece is not high. The light rays enter the cell piece array 3 after being scattered through the sunken structure on the side, deviating from the cell piece array 3, of the glass 1, sunlight is fully utilized, and it can be guaranteed that the whole cell piece array 3 all receives light and generates power, and the cell assembly power is effectively improved. By adopting the solar cell assembly of the present disclosure, the sunlight in various time periods of one day may also be effectively utilized without adopting a sun chasing system, and cell assembly installing cost is lowered.

As shown in FIG. 2 to FIG. 3, H in the front plate of the present embodiment is a thickness of the glass 1, W is a width of the glass 1, L is a length of the glass 1, H₁ in the light scattering units 11 is a maximum length of the sunken structure, W₁ is a width of the sunken structure, and L₁ is a length of the sunken structure. In the present embodiment, a ratio of the maximum depth H₁ of the sunken structure of the light scattering units 11 to the thickness H of the glass is (1 to 100) to (1 to 2), further, the maximum depth H₁ of the sunken structure of the light scattering units 11 is 0.03 mm to 10 mm, and the width W₁ of the sunken structure is 0.3 mm to 50 mm, and the relationship between the length L₁ of the sunken structure and the length L of the glass is L-60 mm≤L₁≤L-10 mm.

The depth of the sunken structure of the present disclosure is at a millimeter level, an anti-reflection effect in the natural environment is stable, self-cleaning performance is better, and a surface is easy to clean. Different from a nanometer level depth of the sunken structure, the nanometer level sunken depth is a very small ion corrosion pit in essence, an anti-reflection contribution of a fine corrosion pit to light is small, the fine corrosion pit is prone to be gradually corroded and ground flat in an environment of sun scorching, rain drenching, wind and sand, and then the anti-reflection effect is reduced; and dirt and other impurities accumulated in a groove of a nanometer structure are not removed easily, and a utilizing rare of the light is further affected.

As shown in FIG. 1 to FIG. 3, preferably, the light scattering units 11 are of a sunken structure extending in a length direction of the glass, an orthographic projection of the light scattering units 11 on a plane where a light receiving surface of the cell piece array 3 is located is rectangular. Specifically, the plurality of light scattering units 11 are distributed at intervals in a width direction of the glass, adjacent light scattering units 11 are connected in a circular arc transition manner, and the structure formed due to connection of circular arc transition is raised relative to a plane where the glass is located. Further, the plurality of light scattering units 11 are continuously distributed at equal intervals in the width direction of the glass 1, and a distance D₁ between edges of the adjacent light scattering units 11 is 0.03 mm to 5 mm, D₁ is actually a width of a bump structure 13 of circular arc transition. And more further, the sunken structure and the bump structure 13 jointly form a wave shape extending in the width direction of the glass 1, that is, a wave line may be seen from a cross section as shown in FIG. 3.

Specifically, the solar cell assembly further comprises an installing outer frame 6, edges all around the glass 1/the front glue film layer 2/the cell piece array 3/the back glue film layer 4/the back plate 5 are coated with the installing outer frame 6 to seal the solar cell assembly, and the side, deviating from the cell piece array, of the glass 1 located in the installing outer frame 6 is a plane, and connection of the installing outer frame 6 and the edges all around the front plate/the front glue film layer 2/the cell piece array 3/the back glue film layer 4/the back plate 5 is in the prior art and is not repeated herein. Further, the side, deviating from the cell piece array, of the glass 1 of the front plate is provided with an encapsulation edge 12 arranged correspondingly to the installing outer frame, and a distance D₂ away from four edges of the glass 1 is 5 mm to 30 mm.

As shown in FIG. 4, a side, facing the cell piece array 3, of the glass 1 of the front plate in the present disclosure, namely a light receiving surface facing the cell piece array 3, may be a smooth surface or a sueded surface (such as frosted glass), the sueded surface commonly refers to a surface with certain roughness. For example, the sueded surface may be a micrometer-level or nanometer-level concave-convex structure, does not have obvious concavity or convexity through unaided viewing, and shows an irregular concave-convex structure only under a viewing device with accuracy at a micrometer or nanometer level. And specifically, a maximum depth of the concave and/or convex structure is far lower than the maximum depth H₁ of the sunken structure of the present application. The other side, namely the side, deviating from the cell piece array 3, of the glass 1, faces sun. Further, a material of the back plate 5 may be the same with or different from a material of the front plate.

When sunlight penetrates through the solar cell glass 1 and is irradiated onto one side of the solar cell piece array 3, the solar cell piece array 3 generates a photovoltaic effect, not all the sunlight irradiated onto the cell piece array 3 is utilized, and much of the sunlight is reflected by the cell piece array 3. When the light reflected out of the cell piece array 3 is reflected to one side of the light scattering units 11 of the sunken structure, the light is reflected and scattered onto one side of the cell piece array 3 again, and participates in power generation again. The process is repeatedly performed heaps of times, therefore, it is guaranteed that the whole silicon wafer can utilize incident light rays very well, that the light receiving area of the glass 1 is increased, and that the assembly power is improved. By adopting the solar cell assembly of the present disclosure, sunlight in various time periods of one day may also be effectively utilized without adopting a sun chasing system, and cell assembly installing cost is lowered.

CN 101677112A in the prior art is a light concentrating principle of convex type light concentrating glass in common use in the field, the light rays are focused on one point by penetrating through the glass. And in actual production, on the one hand, it is needed to consider that convex patterns of the glass need to correspond to a cell piece between fine gate lines (a width of a strip-shaped reflecting light concentrating surface is 0.6 mm to 1.2 mm); on the other hand, correspondence of types of the glass and the cell piece needs to be considered, it is avoided that deviation exists during layout and arrangement of the assembly, the light rays are focused on the gate lines, and then are reflected, and then there are negative effects on improvement of the assembly power. The technical solution of the present disclosure applies a light scattering principle, the light rays are uniform, the light scattering units arranged on the glass enable the front plate to increase an effective reflecting and light scattering surface area on the light receiving surface, a utilizing rate of solar energy is increased, and therefore, the output power of the cell assembly is improved, technical problems existing in CN 101677112A in the prior art are solved, and meanwhile, an experiment proves that the output power is improved by 3% compared with CN 101677112A in the prior art.

The solar cell assembly disclosed by the present disclosure may improve the output power thereof. The solar cell assembly may be installed on a roof of a building or an outer wall of the building, may also be installed in an open space such as desert, and further may be installed on a ship, a satellite, a spacecraft and the like.

In the descriptions of this specification, a description of a reference term such as "an embodiment", "some embodiments", "an example", "a specific example", or "some examples" means that a specific feature, structure, material, or characteristic that is described with reference to the embodiment or the example is included in at least one embodiment or example of the disclosure. In this specification, exemplary descriptions of the foregoing terms do not necessarily refer to a same embodiment or example. In addition, the described specific feature, structure, material, or characteristic may be combined in a proper manner in any one or more embodiments or examples. In addition, with no conflict, a person skilled in the art can integrate and combine different embodiments or examples and features of the different embodiments and examples described in this specification.

The foregoing descriptions are merely preferred embodiments of the present disclosure, but are not intended to limit the present disclosure. Any modification, equivalent replacement, or improvement made within the spirit and principle of the present disclosure shall fall within the protection scope of the present disclosure.

## Claims

1. A solar cell assembly, comprising a front plate, a front glue film layer, a cell piece array, a back glue film layer and a back plate which are sequentially stacked, wherein the front plate comprises glass, a side, deviating from the cell piece array, of the glass is provided with one or more light scattering units, and each light scattering unit is of a sunken structure formed when the side, deviating from the cell piece array, of the glass is sunken inwards towards a side, adjacent to the cell piece array, of the glass.

2. The solar cell assembly according to claim 1, wherein a ratio of a maximum depth H₁ of the sunken structure to a thickness H of the glass is (1 to 100) to (1 to 2).

3. The solar cell assembly according to claim 1, wherein the maximum depth H₁ of the sunken structure is 0.03 mm to 10 mm, and a width W₁ of the sunken structure is 0.3 mm to 50 mm.

4. The solar cell assembly according to claim 1, wherein the relationship between a length L₁ of the sunken structure and a length L of the glass is L-60 mm≤L₁≤L-10 mm.

5. The solar cell assembly according to claim 1, wherein an orthographic projection of the light scattering unit on a plane where a light receiving surface of the cell piece array is located is rectangular.

6. The solar cell assembly according to claim 1, wherein the light scattering unit is of the sunken structure extending in a length direction of the glass.

7. The solar cell assembly according to claim 1, wherein the plurality of light scattering units are distributed at intervals in a width direction of the glass, and adjacent light scattering units are connected in a circular arc transition manner.

8. The solar cell assembly according to claim 7, wherein the sunken structure of the light scattering units and a bump structure in circular arc transition form a wave shape extending in the width direction of the glass.

9. The solar cell assembly according to claim 8, wherein the plurality of light scattering units are continuously distributed at equal intervals in the width direction of the glass, and a distance D₁ between edges of the adjacent light scattering units is 0.03 mm to 5 mm.

10. The solar cell assembly according to claim 1, wherein the solar cell assembly further comprises an installing outer frame, edges all around the front plate/the front glue film layer/the cell piece array/the back glue film layer/the back plate are coated with the installing outer frame to seal the solar cell assembly, and the side, deviating from the cell piece array, of the glass located in the installing outer frame is a plane.

11. The solar cell assembly according to claim 1, wherein a bottom surface of the glass is a smooth surface or a sueded surface.
